Europäisches Patentamt

European Patent Office

Office européen des brevets

(11) Numéro de publication: **0 214 027**
**A1**

## (12) DEMANDE DE BREVET EUROPEEN

(21) Numéro de dépôt: **86401757.9**

(22) Date de dépôt: **05.08.86**

(51) Int. Cl.⁴: **H 01 L 29/743**
**H 01 L 31/10**

(30) Priorité: **06.08.85 FR 8512036**

(43) Date de publication de la demande:
**11.03.87 Bulletin 87/11**

(84) Etats contractants désignés:
**CH DE FR GB IT LI NL**

(71) Demandeur: **THOMSON-CSF**
**173, Boulevard Haussmann**
**F-75379 Paris Cedex 08 (FR)**

(72) Inventeur: **Bacuvier, Pierre**
**THOMSON-CSF SCPI 19, avenue de Messine**
**F-75008 Paris (FR)**

(74) Mandataire: **Guérin, Michel et al**
**THOMSON-CSF SCPI 19, avenue de Messine**
**F-75008 Paris (FR)**

(54) **Thyristor sensible à découplage gachette-cathode intégré.**

(57) L'invention concerne un thyristor sensible.

Pour éviter le déclenchement intempestif d'un thyristor sensible, on lui donne la structure de la figure ci-jointe, avec un sillon passivé SP3 qui divise la couche de gâchette (P1) en deux zones complètement séparées (zone B et zone C). La zone B comprend d'une part la totalité de la région de cathode (N1) et d'autre part une première portion superficielle (P'1) de la couche P adjacente au sillon SP3. La zone C comprend d'une part une région superficielle auxiliaire de type N (N3) et d'autre part une deuxième portion superficielle (P"1) de la couche P1. La métallisation de cathode (CME1) recouvre la région de cathode N1 sans recouvrir la région P'1. La métallisation de gâchette (MG) recouvre au moins partiellement la région P"1. Une métallisation auxiliaire MA séparée des autres recouvre la région P'1 et la région N3.

Cette structure est applicable à un photothyristor.

FIG_1

Coupe AA

EP 0 214 027 A1

**Description**

THYRISTOR SENSIBLE A DECOUPLAGE GACHETTE-CATHODE INTEGRE

L'invention concerne les thyristors et plus particulièrement les thyristors sensibles, c'est-à-dire capables d'être mis en conduction par un courant de gâchette faible (typiquement inférieur à 500 microampères).

Ces thyristors présentent l'avantage de nécessiter une puissance de commande faible, mais cet avantage peut devenir un inconvénient dans la mesure où ces thyristors risquent d'être déclenchés intempestivement par des courants de gâchette parasites même faibles.

En particulier les thyristors sensibles présentent le plus souvent une très mauvaise tenue vis-à-vis des courants parasites engendrés dans le corps semiconducteur en présence de gradients temporels de tension élevés (dV/dt élevés) entre anode et cathode : ils présentent aussi une mauvaise tenue en température, la génération de paires électrons-trous due à la chaleur créant des courants parasites susceptibles de déclencher la mise en conduction du thyristor.

Pour essayer d'améliorer la résistance aux déclenchements intempestifs dus aux forts dV/dt ou dus à la température on a adopté jusqu'à maintenant des solutions consistant à adjoindre entre gâchette et cathode une résistance de découplage extérieure au thyristor, ou parfois une capacité de découplage extérieure ou une combinaison d'une résistance et d'une capacité.

La résistance a pour effet de permettre la récupération par la région de gâchette des courants capacitifs dus aux dV/dt ou les courants de génération thermique de porteurs sans imposer a priori l'injection de la jonction gâchette/cathode mais elle réduit la sensibilité du thyristor ; Cependant, même lorsque la gâchette est connectée, cette résistance n'empêche pas l'établissement d'un chemin de courant entre gâchette et cathode qui sera associé en fonction du dV/dt ou de la température à une circulation interne de courant latéral entre la partie située sous la cathode et la gâchette ; cette circulation latérale interne au thyristor peut provoquer un déclenchement du thyristor. Ce phénomène est d'autant plus critique que la cathode a une largeur plus grande (thyristors puissants). On peut l'éviter partiellement en réduisant les largeurs élémentaires de cathode grâce à une interdigitation de la gâchette et de la cathode mais cela suppose qu'il y ait une interdigitation absolument partout ce qui ne permet pas de prévoir une zone élargie de cathode pour une prise de contact. La technologie de montage des électrodes en est rendue très difficile.

L'utilisation d'une capacité extérieure au thyristor, entre gâchette et cathode, permet d'absorber les courants parasites engendrés par les gradients de tension dV/dt, mais elle n'a pas d'effet sur les porteurs générés thermiquement, et de plus elle introduit un retard de déclenchement lors de la commande de mise en conduction volontaire du thyristor.

La présente invention propose une nouvelle structure de thyristor sensible qui améliore considérablement l'immunité aux déclenchements parasites par gradients de tension anode-cathode (dV/dt) ou par élévation de température, et cela sans faire appel au concept classique d'interdigitation de la cathode.

La structure proposée est la suivante :

Le thyristor comporte un substrat semiconducteur ayant une face arrière recouverte d'une métalisation d'anode et une face avant comportant trois métallisations séparées qui sont respectivement une métallisation de cathode, une métallisation de gâchette, et une métalisation auxiliaire, le thyristor comportant sous les métallisations de la face avant une couche semiconductrice de type P dans laquelle sont diffusées des régions de type N qui sont respectivement une région de cathode et une région auxiliaire de dimensions beaucoup plus faible que la région de cathode ; la couche de type P est divisée en deux zones par un sillon rempli d'une substance de passivation, une première zone contenant d'une part la totalité de la région de cathode et d'autre part une première portion de couche P affleurant à la surface du substrat et adjacente au sillon, et une deuxième zone contenant d'une part la région auxiliaire et d'autre part une deuxième portion de couche P affleurant à la surface ; la métallisation de gâchette recouvre au moins partiellement la deuxième portion de couche P ; la métallisation de cathode recouvre la région de cathode sans recouvrir la première portion de couche P ; et la métallisation auxiliaire recouvre d'une part la première portion de couche P et d'autre part au moins partiellement la région auxiliaire.

Cette métallisation auxiliaire est de préférence une couche continue qui passe au dessus du sillon passivé là où ce sillon passe entre la première portion de couche P et la région auxiliaire.

La région auxiliaire est de préférence non adjacente au sillon, de même d'ailleurs que la région de cathode, celle-ci comprenant par ailleurs une distribution de petits trous dits trous de court-circuit d'émetteur par où la couche de type P remonte à la surface ; ces trous de court-circuit sont recouverts par la métallisation de cathode.

Cette structure améliore considérablement l'immunité du thyristor aux déclenchements parasites dus aux gradients de tension dV/dt et dus à la température.

Dans une variante de réalisation, la couche de type P est de type planar, c'est-à-dire qu'elle est diffusée localement ; dans ce cas, le sillon passivé est remplacé par une remontée du substrat de type N sur la face avant, cette remontée étant recouvert d'une couche isolante de passivation.

D'autres caractéristique et avantages de l'invention apparaîtront à la lecture de la description détaillée qui suit et qui est faite en référence aux dessins annexés dans lesquels :

    - la figure 1 représente une coupe transversale, selon la ligne brisée AA de la figure 2, du thyristor selon l'invention,

    - la figure 2 représente une vue de dessus de ce thyristor où on a superposé en transparence aussi bien les régions de type N de la face supérieure que les sillons passivés et les différentes métallisations.

Le thyristor comprend classiquement les éléments suivants :
- une couche centrale N2 de type de conductivité N forme le corps du substrat semiconducteur,
- une couche P1 de type P est formée du côté supérieur de la couche N2, et recouvre la totalité de la couche N2, et une couche P2 de type P est formée du côté inférieur et recouvre également la totalité de la couche N2,
- une région de cathode N1 est diffusée sur une partie de la surface supérieure du substrat et sur une profondeur plus faible que l'épaisseur de la couche P2. Cette région est percée de trous CC1 par lesquels la couche P1 remonte à la surface du substrat ; ces trous dits court-circuits d'émetteur sont connus en soi ; ils améliorent l'homogénéité de déclenchement du thyristor ; on notera que les thyristors sensibles sont en principe dépourvus de tels trous car ils détériorent la sensibilité ; ici on en prévoit car la structure selon l'invention permet de prévoir ces trous de court-circuit sans détériorer la sensibilité du thyristor ; on bénéficie donc d'une meilleure homogénéité d'amorçage avec une bonne sensibilité de déclenchement,
- une métallisation d'anode ME2 recouvre la majeure partie de la surface inférieure du substrat ; elle est donc en contact avec la couche P2,
- une métallisation de cathode ME1 recouvre la région de cathode N1 y compris les trous de court-circuit CC1 ; elle ne s'étend pas sur tote la surface supérieure du substrat,
- un sillon périphérique SP2 rempli d'une substance de passivation (verre) entoure le substrat sur toute la périphérie de la surface inférieure ; sa profondeur est supérieure à celle de la couche P2 et il coupe donc la jonction entre les couches P2 et N2 pour améliorer la tenue en tension inverse de cette jonction,
- de même, un sillon périphérique SP1 rempli d'une substance de passivation (verre) entoure le substrat sur toute la périphérie de la surface supérieure ; sa profondeur est supérieure à celle de la couche P1 et il coupe donc la jonction entre les couches P1 et N2 pour améliorer la tenue en tension inverse de cette jonction.

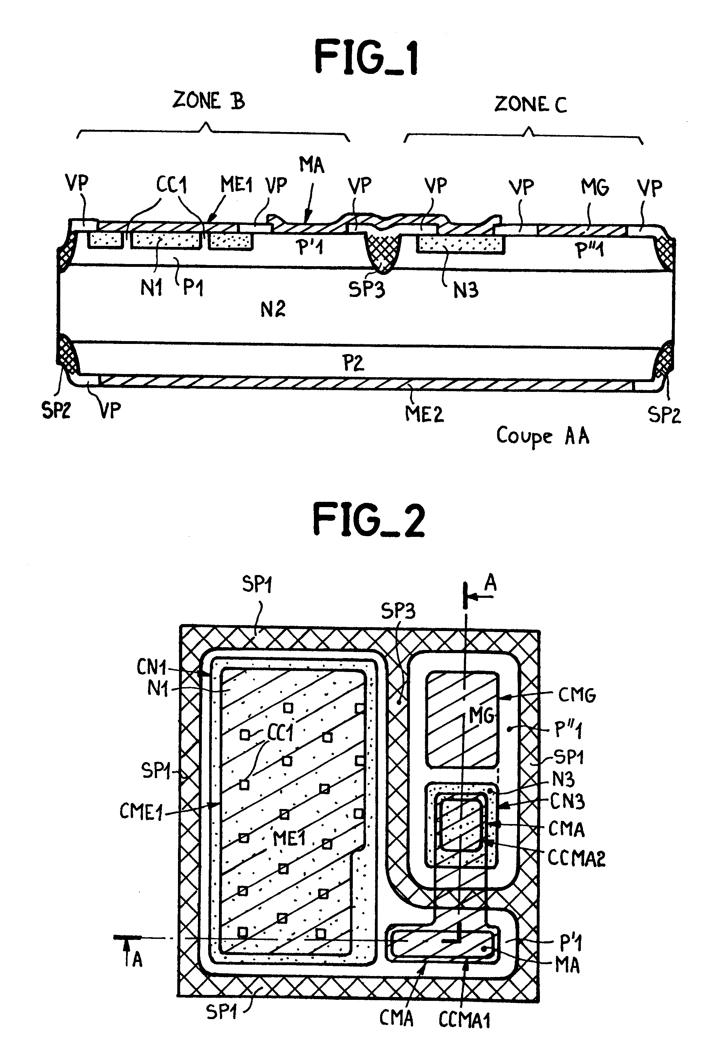

Sur la figure 2, on notera que l'étendue des régions de type N (N1 notamment) diffusées dans la couche P1 est constellée de petits points ; le tracé des sillons passivés (SP1 notamment) est hachuré en traits croisés ; les métallisations (ME1 notamment) sont hachurées en traits obliques ; les parties qui ne sont ni hachurées en croix ni pointillées sont en fait des zones où la couche P1 affleure à la surface supérieure ; enfin, les parties qui ne sont ni hachurées en traits obliques ni hachurées en croix (qu'elles soient pointillées ou non) sont des parties recouvertes d'un verre de passivation VP qui est prévu à certains endroits en dehors des sillons (notamment sur tout le contour où la jonction entre les régions N1 et P1 remonte à la surface).

Sur la figure 2, le contour de la région N1 est désigné par CN1, celui de la métallisation ME1 par CME1.

Les particularités du thyristor sensible selon l'invention sont les suivantes (en plus des trous de court-circuit dont on a dit qu'ils étaient absents dans les thyristors sensibles connus) :
La couche P1 de type P est divisée en deux zones par un sillon supplémentaire SP3 rempli d'une substance de passivation et formé en même temps que le sillon SP1 ; ces deux zones sont une zone B (à gauche sur la figure 1) et une zone C (à droite sur la figure 1, en haut et à droite sur la figure 2).

La première zone comporte la totalité de la région de cathode N1 avec ses trous de court-circuit, la totalité de la métallisation de cathode ME1, et elle comporte en plus une petite portion de région P1, désignée par P'1 sur les figures, portion qui affleure à la surface supérieure du substrat et qui n'est pas recouverte par la métallisation de cathode ME1.

Cette petite portion P'1 est en partie directement recouverte par une métallisation auxiliaire MA séparée de la métallisation de cathode ME1 et en partie recouverte par du verre de passivation VP ; le contour de la métallisation auxiliaire MA est désigné par CMA sur la figure 2 ; le contour de la région de contact entre la métallisation MA et la région P'1 est désigné par CCMA1, la métallisation auxiliaire s'étendant en effet non seulement sur cette région de contact mais aussi au-dessus du verre de passivation VP qui l'entoure et même au-dessus du sillon passivé SP3 et au delà.

La deuxième zone de la couche de type P, zone C, l'autre côté du sillon supplémentaire SP3 a une surface plus faible que la première zone.

Cette deuxième zone comporte une portion de région de type P affleurant à la surface supérieure du substrat, désignée par P"1, recouverte en partie par une métallisation de gâchette MG et en partie par du verre de passivation VP. Le contour de la métallisation de gâchette est désigné par CMG sur la figure 2.

D'autre part, la deuxième zone C comporte également une région auxiliaire N3 de type N, diffusée dans la zone C mais de préférence non adjacente aux sillons passivés ; cette région N3 est à proximité de la région P'1 de la zone B ; elle n'en est séparée que par le sillon SP3 et par un petit intervalle de région P"1 affleurant à la surface et recouvert de verre de passivation. Le contour de la région N3 est désigné par CN3 sur la figure 2.

Au milieu de la région N3 est prévue une ouverture dans le verre de passivation, ouverture recouverte d'une métallisation qui est une partie de la métallisation auxiliaire MA. En effet, cette métallisation MA s'étend non seulement dans la zone B mais elle traverse le sillon SP3 et va dans la zone C jusqu'à contacter la région N3 en restant isolée (par le verre de passivation) de la couche P"1 de la zone C. Sur la figure 2, le contour de l'ouverture de contact au-dessus de la région N3 est désignée par CCMA2.

Le thyristor fonctionne de la manière suivante : la zone C constitue un thyristor sensible dont le déclenchement provoque le déclenchement du thyristor principal de la zone B. Mais ce thyristor sensible de la zone C est peu sujet à un risque de déclenchement intempestif sous l'effet des gradients de tension dV/dt ou sous l'effet de la température.

En effet, l'émetteur (cathode) N3 du thyristor sensible situé dans la zone C peut être réalisé avec une largeur très faible ce qui rendra particulièrement efficace l'effet du découplage externe par une résistance et/ou une capacité placée entre gâchette et cathode. Cette cathode très étroite ne pose cependant aucun problème lors de l'assemblage puisque la métallisation MA, formée par dépôt et gravure photolithographique, n'a pas à être connectée à une borne extérieure comme les autres métallisations.

L'étage de puissance, (zone B), de conception classique, présente lui-même une très bonne immunité grâce aux trous de court-circuit CC1 judicieusement répartis. N'ayant pas besoin d'être interdigité, il ne posera aucun problème lors de l'assemblage.

Dans une variante de réalisation non représentée, le thyristor est constitué avec une structure de type "planar", c'est-à-dire que la couche P1, au lieu d'être diffusée sur toute la surface du substrat, est diffusée localement. Dans ce cas, le sillon passivé SP3, sur lequel venaient s'arrêter la jonction entre la région P1 et la région N2, est remplacé par une région semiconductrice de type N recouverte d'une couche isolante de passivation. Cette région de type N est une remontée de la région de substrat N2 qui va jusqu'à la surface supérieure et qui est encadrée par les bords de la région P1 de la zone B d'un côté et les bords de la région P1 de la zone C de l'autre côté. La remontée de substrat a le même contour que le sillon SP3 ; la métallisation auxiliaire MA passe au dessus de cette remontée, et elle en est isolée par la couche isolante de passivation.

Enfin, les deux modes de réalisation sont utilisables dans le cas d'un thyristor photodéclenchable, c'est-à-dire un thyristor qui n'est pas déclenché par un courant de gâchette mais par une illumination. Même dans ce cas une métallisation de gâchette peut être conservée pour la connexion de résistances extérieures entre gâchette et cathode.

**Revendications**

1. Thyristor sensible comportant un substrat semiconducteur ayant une face arrière recouverte d'une métallisation d'anode (ME2) et une face avant comportant une métallisation de cathode (ME1) et une métallisation de gâchette (MG), le thyristor comportant sous les métallisations de la face avant une couche semiconductrice (P1) de type P occupant toute la surface du substrat, et une région de cathode (N1) de type N étant localement diffusée dans la couche de type P, caractérisé en ce que la couche de type P est divisée en deux zones séparées par un sillon (SP3) rempli d'une substance de passivation, une première zone (B) contenant d'une part la totalité de la région de cathode et d'autre part une première portion (P'1) de couche P affleurant à la surface du substrat et adjacente au sillon, et une deuxième zone (C) contenant d'une part une région auxiliaire (N3) de type N diffusée dans la couche de type P et d'autre part une deuxième portion (P"1) de couche de type P affleurant à la surface, la métallisation de gâchette recouvrant au moins partiellement la deuxième portion de couche P, la métallisation de cathode recouvrant la région de cathode sans recouvrir la première portion de couche P, et une métallisation auxiliaire (MA) étant prévue, séparée des autres métallisations, cette métallisation recouvrant d'une part au moins partiellement la première portion de couche de type P et d'autre part au moins partiellement la région auxiliaire de type N.

2. Thyristor sensible selon la revendication 1, caractérisé en ce que la région auxiliaire (N3) n'est pas adjacente au sillon supplémentaire (SP3).

3. Thyristor sensible selon la revendication 1, caractérisé en ce que la région de cathode comprend des trous de court-circuit (CC1) par lesquels la couche de type P (P1) remonte à la surface supérieure du substrat.

4. Thyristor sensible selon la revendication 1, caractérisé en ce que la métallisation auxiliaire est une couche continue passant au-dessus du sillon passivé là où ce sillon passe entre la première portion de couche P et la région auxiliaire.

5. Thyristor sensible comportant un substrat semiconducteur ayant une face arrière recouverte d'une métallisation d'anode (ME2) et une face avant comportant une métallisation de cathode (ME1) et une métallisation de gâchette (MG), le thyristor comportant sous les métallisations de la face avant une couche semiconductrice (P1) de type P localement diffusée à la surface du substrat, et une région de cathode (N1) de type N étant localement diffusée dans la couche de type P, caractérisé en ce que la couche de type P est divisée en deux zones principales séparées par une région de substrat de type N remontant à la surface et recouverte par une couche isolante de passivation, ces deux zones étant respectivement une première zone (B) contenant d'une part la totalité de la région de cathode et d'autre part une première portion (P'1) de couche P affleurant à la surface du substrat et adjacente à la région de substrat remontant à la surface, et une deuxième zone (C) contenant d'une part une région auxiliaire (N3) de type N diffusée dans la couche de type P et d'autre part une deuxième portion (P"1) de couche de type P affleurant à la surface, la métallisation de gâchette recouvrant au moins partiellement la deuxième portion de couche P, la métallisation de cathode recouvrant la région de cathode sans recouvrir la première portion de couche P, et une métallisation auxiliaire (MA) étant prévue, séparée des autres métallisations, cette métallisation recouvrant d'une part au moins partiellement la première portion de couche de type P et d'autre part au moins partiellement la région auxiliaire de type N.

6. Thyristor sensible selon la revendication 5, caractérisé en ce que la région auxiliaire (N3) ne rejoint pas la région de substrat N remontant à la surface.

7. Thyristor sensible selon la revendication 5, caractérisé en ce que la région de cathode comprend des trous de court-circuit (CC1) par lesquels la couche de type P (P1) remonte à la surface supérieure du substrat.

8. Thyristor sensible selon la revendication 5, caractérisé en ce que la métallisation auxiliaire est une couche continue passant au dessus de la couche isolante de passivation entre la première portion de couche P et la région auxiliaire.

9. Thyristor sensible selon l'une des revendications précédentes, caractérisé en ce que le thyristor est photodéclenchable.

FIG_1

86401757 9

FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | EP-A-0 143 259 (K.K. TOSHIBA) * Revendications 1-7; figures 2A,2B * | 1,5 | H 01 L 29/743 H 01 L 31/10 |
| | --- | | |
| A | PATENTS ABSTRACTS OF JAPAN, vol. 5, no. 197 (E-86)[869], 15 décembre 1981; & JP-A-56 116 666 (NIPPON DENKI K.K.) 12-09-1981 | 1 | |
| | --- | | |
| A | DE-A-2 722 064 (BBC AG BROWN, BOVERI & CIE) * Page 16, lignes 7-25; figure 4 * | 1,5,9 | |
| | --- | | |
| A | US-A-4 314 266 (V.A.K. TEMPLE) | | |
| | --- | | |
| A | EP-A-0 110 551 (TOKYO SHIBAURA DENKI K.K.) | | |
| | ----- | | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 10-11-1986 | ZOLLFRANK G.O. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82